# EUROPÄISCHE PATENTSCHRIFT

(11) **EP 2 218 107 B1**
(45) Veröffentlichungstag und Bekanntmachung des Hinweises auf die Patenterteilung: **19.10.2016**
(21) Anmeldenummer: 08858904.9
(22) Anmeldetag: 28.11.2008
(51) Int. Cl.: H01L 31/0224, H01L 31/0352, H01L 31/068

(54) **RÜCKKONTAKTSOLARZELLE MIT LÄNGLICHEN, INEINANDER VERSCHACHTELTEN EMITTER- UND BASISBEREICHEN AN DER RÜCKSEITE UND HERSTELLUNGSVERFAHREN HIERFÜR**
REAR-CONTACT SOLAR CELL HAVING ELONGATE, NESTED EMITTER AND BASE REGIONS ON THE REAR SIDE AND METHOD FOR PRODUCING THE SAME
CELLULE SOLAIRE À CONTACT ARRIÈRE COMPORTANT DES ZONES D'ÉMETTEUR ET DE BASE ALLONGÉES, ENCASTRÉES LES UNES DANS LES AUTRES SUR LE CÔTÉ ARRIÈRE, ET PROCÉDÉ DE FABRICATION DE LA CELLULE SOLAIRE

(30) Priorität: 11.12.2007 DE 102007059486
(43) Veröffentlichungstag der Anmeldung: 18.08.2010
(73) Patentinhaber: Institut für Solarenergieforschung GmbH, 31860 Emmerthal (DE)
(72) Erfinder: HARDER, Nils-Peter, 31787 Hameln (DE)
(74) Vertreter: Qip Patentanwälte Dr. Kuehn & Partner mbB
(86) Internationale Anmeldenummer: PCT/EP2008/066432
(87) Internationale Veröffentlichungsnummer: WO 2009/074466

(56) Entgegenhaltungen:
- WO-A-03/083955
- US-A- 4 916 503
- US-A- 6 034 321

## Beschreibung

### BEREICH DER ERFINDUNG

Die vorliegende Erfindung betrifft eine Rückkontaktsolarzelle mit länglichen, ineinander verschachtelten Emitter- und Basisbereichen an der Rückseite sowie ein Herstellungsverfahren für eine solche Rückkontaktsolarzelle.

### HINTERGRUND DER ERFINDUNG

Konventionelle Solarzellen haben einen vorderseitigen Kontakt, das heißt einen Kontakt, der auf einer dem Licht zugewandten Oberfläche der Solarzelle angeordnet ist, und einen rückseitigen Kontakt an einer dem Licht abgewandten Oberfläche der Solarzelle. In diesen konventionellen Solarzellen ist der größte Volumenanteil eines das Licht absorbierenden Halbleitersubstrats von eben dem Halbleitertyp (zum Beispiel p-Typ), der vom rückseitigen Kontakt kontaktiert wird. Dieser Volumenanteil wird üblicherweise als Basis bezeichnet und die rückseitigen Kontakte werden daher üblicherweise als Basiskontakte bezeichnet. Im Bereich der Oberfläche der Vorderseite des Halbleitersubstrats befindet sich eine dünne Schicht vom entgegengesetzten Halbleitertyp (zum Beispiel n-Typ). Diese Schicht wird üblicherweise als Emitter bezeichnet und die sie kontaktierenden Kontakte als Emitterkontakte.

Bei solchen herkömmlichen Solarzellen liegt somit der für die Stromsammlung entscheidende pn-Übergang dicht unter der vorderseitigen Oberfläche der Solarzelle. Diese Position des pn-Übergangs ist insbesondere bei der Verwendung von Halbleitermaterial schlechter bis mittlerer Qualität für eine effiziente Stromsammlung vorteilhaft, da auf der dem Licht zugewandten Seite der Solarzelle die höchste Generationsrate von Ladungsträgerpaaren vorliegt und somit die meisten Licht-generierten (Minoritäts-) Ladungsträger nur eine kurze Distanz zum pn-Übergang zurücklegen müssen.

Die an der Vorderseite der Solarzelle angeordneten Emitterkontakte führen jedoch aufgrund der mit ihnen verbundenen teilweisen Abschattung der Vorderseite zu einem Wirkungsgradverlust. Um den Wirkungsgrad der Solarzelle zu steigern, ist es grundsätzlich vorteilhaft, sowohl die Basiskontakte als auch die Emitterkontakte an der Rückseite der Solarzelle anzuordnen. Zu diesem Zweck müssen an der Rückseite der Solarzelle entsprechende Emitterbereiche ausgebildet werden. Eine Solarzelle, bei der sich an der im Einsatz lichtabgewandten Seite sowohl Emitterbereiche als auch Basisbereiche befinden und bei der sowohl die Emitterkontakte als auch die Basiskontakte an der Rückseite ausgebildet sind, wird als Rückkontaktsolarzelle bezeichnet.

Bei solchen Rückkontaktsolarzellen, deren Strom-sammelnder pn-Übergang zumindest teilweise an der Rückseite der Solarzelle angeordnet ist, muss mit der Problematik umgegangen werden, dass sowohl die Emitterbereiche als auch die Basisbereiche an der Rückseite der Solarzelle nebeneinander angeordnet sind. Somit kann der pn-Übergang nicht mehr entlang der gesamten Oberfläche der Solarzelle ausgebildet werden, sondern die ihn zusammen mit dem Volumen-Basisbereich bildenden rückseitigen Emitterbereiche können nur noch an einem Teil der Rückseiten-Oberfläche der Solarzelle ausgebildet werden.

Dazwischen müssen rückseitige Basisbereiche zur Kontaktierung der Basis vorgesehen sein.

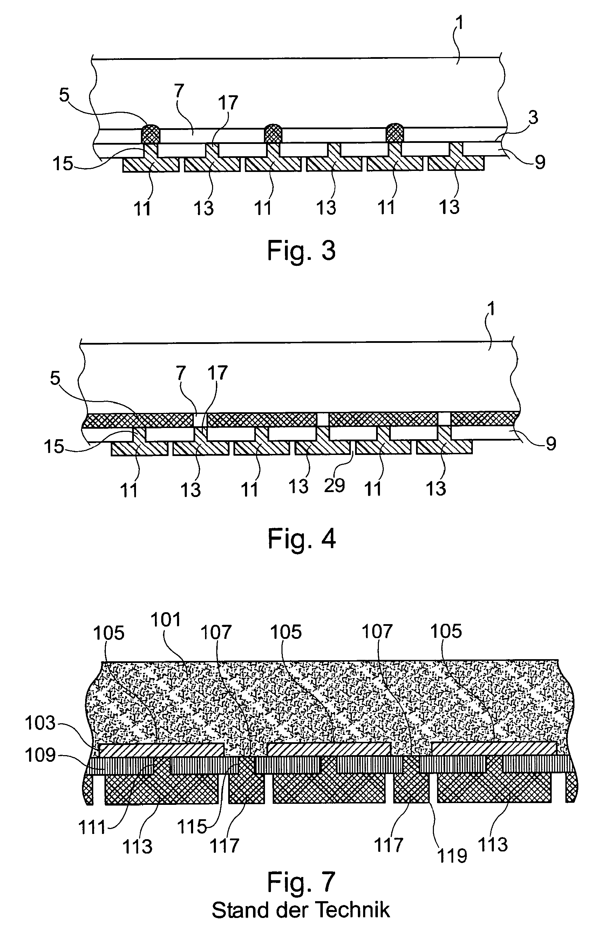

Ein Beispiel einer herkömmlichen Rückkontaktsolarzelle ist in Fig. 7 im Querschnitt dargestellt. Ein Halbleitersubstrat 101 bildet in seinem Volumen einen Basisbereich beispielsweise vom p-Halbleitertyp. An einer Rückseiten-Oberfläche 103 sind Emitterbereiche 105 ausgebildet. Die Emitterbereiche 105 belegen den überwiegenden Anteil der Rückseiten-Oberfläche 103. Zwischen den länglichen, fingerförmigen Emitterbereichen 105 sind schmale, linienförmige Bereiche freigelassen, an denen Basisbereiche 107 des Halbleitersubstrats 101 bis an die Rückseiten-Oberfläche 103 reichen. Die Rückseiten-Oberfläche 103 ist mit einer dielektrischen Passivierschicht 109 bedeckt, die einen geringen Brechungsindex aufweisen kann, so dass sie zum Beispiel als rückseitiger Reflektor für die Solarzelle dienen kann, und die beispielsweise aus Siliziumdioxid ausgebildet sein kann. Die Passivierschicht 109 weist lokal Öffnungen 111 auf, durch die hindurch Emitterkontakte 113 die Emitterbereiche 105 kontaktieren können. Ferner weist die Dielektrikumschicht 109 Öffnungen 115 auf, durch die hindurch Basiskontakte 117 die lokal bis zur rückseitigen Oberfläche reichenden Basisbereiche 107 kontaktieren können. Die Emitterkontakte 113 und die Basiskontakte 117 sind durch schmale Spalte 119 voneinander getrennt und somit elektrisch isoliert.

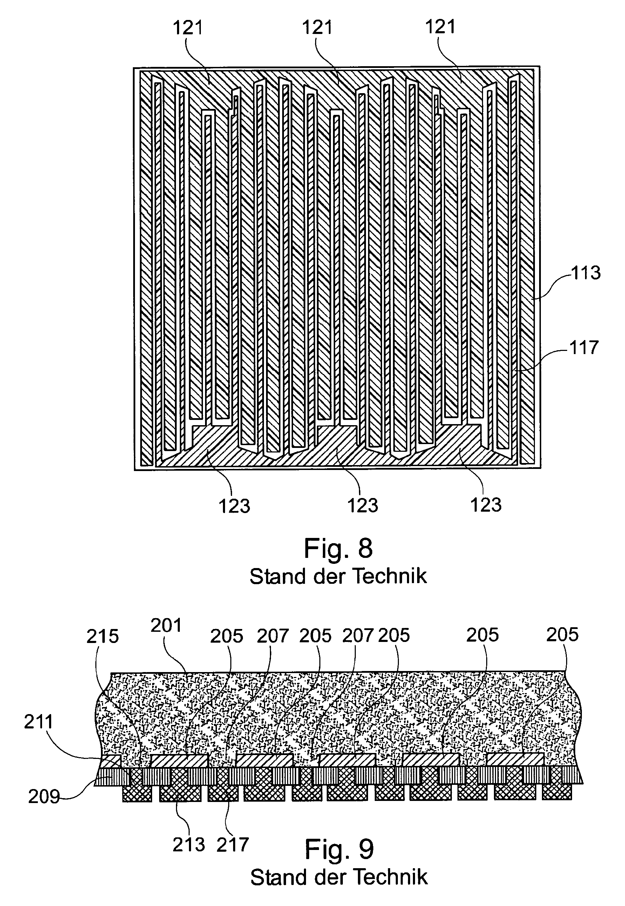

Fig. 8 zeigt eine Draufsicht auf die Rückseite der in Fig. 7 dargestellten herkömmlichen Rückkontaktsolarzelle. Es ist zu erkennen, wie längliche, fingerförmige Emitter- und Basiskontakte 113, 117 kammartig ineinander verschachtelt angeordnet sind. Die Emitterkontakte 113 weisen dabei eine wesentlich größere Breite auf als die Basiskontakte 117. An ihren seitlichen Enden münden die Emitterkontakte 113 in Strom-sammelnde Emitter-Busbars 121, welche als Verbreiterungen der Emitter-Metallisierung an einem Rand der Solarzelle ausgebildet sind. Dementsprechend münden die Basiskontakte 117 in Basis-Busbars 123 am gegenüber liegendem Rand der Zellrückseite.

Bei der beschriebenen herkömmlichen Rückkontaktsolarzelle besteht folgendes Optimierungsproblem: für ein effektives Einsammeln der durch Licht im Basissubstrat 101 erzeugten Ladungsträger ist ein möglichst großflächiger Emitterbereich 105, das heißt ein möglichst großflächiger pn-Übergang von Vorteil, damit die erzeugten Minoritätsladungsträger kurze Wege zu dem pn-Übergang haben und eingesammelt werden können, bevor sie rekombinieren. Ein großflächiger Emitter impliziert jedoch bei diesem herkömmlichen Solarzellen-Konzept lange Wege für die Majoritätsladungsträger innerhalb des Basissubstrats 101. Dies kann, insbesondere bei schwach dotierten Basissubstraten mit geringer Leitfähigkeit, zu Widerstandsverlusten führen. Eine Zelloptimierung muss also in Abwägung zwischen optimaler Stromsammlung und Serienwiderstandsminimierung erfolgen.

Diese Problematik stellt sich in verschärfter Weise unter den Busbars 121, 123 der Solarzelle, bei denen die fingerförmigen Kontakte 113, 117 zusammengeführt werden. Hier tragen die Busbars die Summe des Stroms mehrerer Kontaktfinger bis zu den Stromabnahmepunkten, den "Lötpads". Da die Stromstärke hier größer ist, müssen die Busbars, wie in Fig. 8 gezeigt, breiter ausgestaltet sein als die Kontaktfinger selbst. Insbesondere unter dem Emitter-Busbar 121 erhöht sich daher das Serienwiderstandsproblem sehr deutlich und kann somit den Wirkungsgrad der gesamten Solarzelle senken. Im Bereich des Basis-Busbars 123, wo sich bei diesem herkömmlichen Zellkonzept kein Emitter befindet, kann es außerdem zu einer verminderten Stromsammelfähigkeit kommen, was ebenfalls zu negativen Auswirkungen auf den Wirkungsgrad der gesamten Solarzelle führen kann. Die für den Emitterbusbar und den Basisbusbar genannten Verluste treten zusätzlich verstärkt unter den verbreiterten Bereichen der Busbars auf, die als Lötpads dienen.

Ein weiterer, bei der Optimierung von Rückkontaktsolarzellen zu berücksichtigender Aspekt ist, dass aus Gründen der Herstellungskostenminimierung in der Regel die Emitterkontakte 113 und die Basiskontakte 117 in einem gemeinsamen Verfahrensschritt aufgebracht werden, beispielsweise durch Aufdampfen von Metall. Somit sind beide Kontakttypen im Wesentlichen gleich dick. Die Basiskontakte 117 sind jedoch bei der in den Fign. 7 und 8 gezeigten Rückkontaktsolarzelle wesentlich schmaler als die Emitterkontakte 113. Da beide Kontakte 113, 117 den gleichen Strom abführen müssen, ergibt sich jedoch, dass bei Aufbringen einer Metallschichtdicke für die Kontakte, die für eine effiziente Stromableitung von der Basis durch die Basiskontakte ausreichend ist, die Emitterkontakte wesentlich dicker als erforderlich sind. Mit anderen Worten wird, wenn Basis- und Emitterkontakte in einem gemeinsamen Prozessschritt abgeschieden werden, auf den großflächigeren Emitterkontakten unnötig viel Metall abgeschieden. Das Aufbringen der Metallisierung für die Kontakte und auch die zugehörigen Materialkosten stellen jedoch einen erheblichen Anteil der Gesamtkosten der Solarzellen dar.

Es kann daher erstrebenswert sein, die Metallkontakte sowohl für die Emitter- als auch die Basiskontakte in etwa gleicher Breite auszubilden und dabei vorzugsweise beide Kontakttypen möglichst breit anzufertigen, so dass bei geringer Metallschichtdicke ein möglichst geringer elektrischer Widerstand in den Metallkontakten erreicht werden kann.

In einem Versuch, den oben geschilderten, teilweise gegensätzlichen Anforderungen an eine Rückkontaktsolarzelle gerecht zu werden, wurden Rückkontaktsolarzellen entwickelt, wie sie in Fig. 9 schematisch dargestellt sind. Diese Rückkontaktsolarzellen weisen sehr feine Strukturen sowohl für die Basis- und Emitterbereiche 205, 207 wie auch für die Basis- und Emitterkontakte 213, 217 auf. Die Strukturbreiten liegen hierbei typischerweise zwischen 5µm und 100 µm.

Der dargestellte Solarzellentyp weist nur schmale Emitterbereiche 205 auf, die den Stromsammelnden pn-Übergang bilden. Dazwischen liegen jeweils schmale Basisbereiche 207. Hierdurch kann gewährleistet werden, dass die Majoritätsladungsträger nur kurze Wege im Innern des Halbleitersubstrats 201 hin zu den Basisbereichen 207 und dann zu den Basiskontakten 217 zurückzulegen brauchen. Gleichzeitig ist durch den geringen Abstand zwischen benachbarten Emitterbereichen 205 gewährleistet, dass die Minoritätsladungsträger nur kurze Wege zu einem Strom-sammelnden pn-Übergang zurückzulegen haben, wodurch eine gute Stromsammeleffizienz gewährleistet werden kann.

Allerdings hat sich herausgestellt, dass es eine große technologische Herausforderung insbesondere für eine kostengünstige Massenproduktion von großflächigen Rückkontaktsolarzellen darstellen kann, sowohl Emitter- und Basisbereiche als auch Emitter- und Basiskontakte mit derart feinen Strukturen mit Breiten von 5 bis 100 µm fehlerfrei herzustellen. Im Labormaßstab werden hierfür häufig hoch präzise Verfahren wie zum Beispiel die Fotolithographie eingesetzt. Diese Fertigungsverfahren müssen mit sehr hoher Zuverlässigkeit ausgeführt werden, da bereits einzelne Fehler, insbesondere bei der Kontakttrennung zwischen benachbarten Fingern der Emitter- und Basiskontakte zu einer erheblichen Schädigung der Solarzelle führen können. Daher haben sich entsprechend fein strukturierte Rückkontaktsolarzellen für eine großindustrielle Massenfertigung von billigen Solarzellen als weitgehend ungeeignet herausgestellt.

Ein weiteres Problem bei der fein strukturierten Rückkontaktsolarzelle aus Fig. 9 kann darin bestehen, dass aufgrund der kleinen Strukturbreiten die zwangsweise zwischen benachbarten Emitter- und Basiskontakten 213, 217 für eine elektrischen Isolation vorzusehenden Spalte 219 einen erheblichen Anteil an der Rückseiten-Oberfläche der Solarzelle einnehmen können. Infolgedessen muss die Dicke der Kontaktfinger entsprechend hoch gewählt werden, um ausreichend viel Metall bereitzustellen, so dass ein geringer Serienwiderstand für den lateralen Stromtransport erreicht werden kann. Die Herstellung solch schmaler und gleichzeitig hoher Metallkontakte ist technologisch schwierig bzw. mit erhöhten Kosten verbunden, insbesondere bei Beschichtungsverfahren wie Sputtern oder Galvanik.

### ZUSAMMENFASSUNG DER ERFINDUNG

Es kann daher ein Bedarf an einer Rückkontaktsolarzelle und an einem Verfahren zur Herstellung einer Rückkontaktsolarzelle bestehen, bei der/dem die oben genannten Probleme herkömmlicher Rückkontaktsolarzellen zumindest teilweise gelöst werden können. Insbesondere kann ein Bedarf an einer Rückkontaktsolarzelle bestehen, die einerseits gute Strom-sammelnde Eigenschaften aufweist und die andererseits geringe Serienwiderstände innerhalb der Basis zulässt. Es kann dabei erstrebenswert sein, dass eine solche Solarzelle in technologisch einfacher, reproduzierbarer und zuverlässiger Weise und bei geringen Kosten herstellbar ist.

Dieser Bedarf kann durch den Gegenstand der unabhängigen Ansprüche erfüllt werden. Vorteilhafte Ausführungsformen der vorliegenden Erfindung sind in den abhängigen Ansprüchen sowie in der nachfolgenden Beschreibung beschrieben.

Gemäß einem ersten Aspekt der vorliegenden Erfindung wird eine Rückkontaktsolarzelle beschrieben, die ein Halbleitersubstrat, längliche Emitterbereiche an einer Rückseiten-Oberfläche des Halbleitersubstrats, längliche Basisbereiche an der Rückseiten-Oberfläche des Halbleitersubstrats, längliche Emitterkontakte quer zu den länglichen Emitterbereichen zur elektrischen Kontaktierung der Emitterbereiche und längliche Basiskontakte quer zu den länglichen Emitterbereichen zur elektrischen Kontaktierung der Basisbereiche aufweist. Das Halbleitersubstrat weist vorzugsweise einen Basis-Halbleitertyp auf, der entweder ein n-Halbleitertyp oder ein p-Halbleitertyp sein kann. Die länglichen Basisbereiche an der Rückseiten-Oberfläche weisen ebenfalls den Basis-Halbleitertyp auf. Die Emitterbereiche weisen einen dem Basis-Halbleitertyp entgegengesetzten Emitter-Halbleitertyp auf. Die länglichen Emitterbereiche weisen kleinere Strukturbreiten auf als die länglichen Emitterkontakte und die länglichen Basisbereiche weisen kleinere Strukturbreiten auf als die länglichen Basiskontakte. Die mehrere längliche Emitterbereiche und mehrere längliche Basisbereiche sind jeweils abwechselnd benachbart aneinander angrenzend und parallel zueinander angeordnet und die mehrere längliche Emitterkontakte und mehrere längliche Basiskontakte sind jeweils abwechselnd und parallel zueinander angeordnet. Der Mittenabstand (We, Wb) zwischen benachbarten Emitter- und Basisbereichen ist kleiner als der Mittenabstand (WE, WB) zwischen benachbarten Emitter- und Basiskontakten.

Dieser erste Aspekt der vorliegenden Erfindung kann als auf der folgenden Idee basierend angesehen werden: An der Rückseiten-Oberfläche der Solarzelle werden sowohl schmale längliche Basisbereiche als auch schmale längliche Emitterbereiche ausgebildet, wobei die Basis- und Emitterbereiche benachbart aneinander angrenzend und kammartig ineinander verzahnt ausgebildet sein können. Um die jeweiligen Emitter- und Basisbereiche elektrisch zu kontaktieren, werden längliche Emitter- und Basiskontakte vorgesehen. Diese verlaufen jeweils quer zu den Emitter- und Basisbereichen und können letztere zumindest in Teilbereichen der Rückseite der Solarzelle kreuzen. Durch geeignete Maßnahmen, wie sie beispielhaft weiter unten in Bezug auf bevorzugte Ausführungsformen detaillierter dargestellt werden, kann gewährleistet werden, dass die Emitterkontakte ausschließlich die Emitterbereiche, nicht jedoch die Basisbereiche kontaktieren und dass umgekehrt die Basiskontakte ausschließlich die Basisbereiche, nicht jedoch die Emitterbereiche kontaktieren.

Bei dem vorgeschlagen Zellkonzept kann unter anderem erreicht werden, dass die Strukturbreiten der Emitter- und Basiskontakte unabhängig von denjenigen der Emitter- und Basisbereiche gewählt werden können. Auf diese Weise kann bei der Optimierung der Solarzelle den teilweise gegensätzlichen Anforderungen an die geometrische Anordnung und an die Strukturbreiten der Emitter- und Basisbereiche einerseits und der Emitter- und Basiskontakte andererseits Rechnung getragen werden. Es hat sich nun als vorteilhaft herausgestellt, die Strukturbreiten der Emitter- und Basisbereiche kleiner als die Strukturbreiten der Emitter- und Basiskontakte zu wählen. Einerseits können durch schmale und eng benachbarte Emitterbereiche und dazwischen verlaufende schmale und ebenfalls eng benachbarte Basisbereiche sowohl gute Strom-sammelnde Eigenschaften wie auch geringe Serienwiderstandsverluste innerhalb der Basis erreicht werden. Andererseits kann durch verhältnismäßig breite Emitter- und Basiskontakte eine einfache und zuverlässige Herstellung der Kontakte erreicht werden. Außerdem können die Emitter- und Basiskontakte flächenmäßig etwa gleich groß ausgebildet werden, so dass in einem gemeinsamen Prozessschritt beide Kontakttypen mit der gleichen Dicke ausgebildet werden können, ohne dass einer der Kontakttypen bezogen auf seine Fläche eine verschwenderisch große Dicke aufweisen würde und ohne dass im anderen Falle einer der Kontakttypen bei gegebener Metallisierungsdicke aufgrund seiner geringeren Breite einen zu großen elektrischen Widerstand darstellen würde.

Weitere Merkmale, Einzelheiten und mögliche Vorteile von Ausführungsformen der erfindungsgemäßen Rückkontaktsolarzelle werden im Anschluss erläutert.

Das für die Rückkontaktsolarzelle verwendete Halbleitersubstrat kann beispielsweise ein mono- oder multikristalliner Siliziumwafer sein. Alternativ können auch Dünnschichten aus amorphem oder kristallinem Silizium oder aus anderen halbleitenden Materialien als Substrat verwendet werden.

Die länglichen Emitterbereiche können durch Eindiffundieren von Dotanden in das Halbleitersubstrat erzeugt werden. Beispielsweise kann in einem Halbleitersubstrat vom p-Typ durch lokales Eindiffundieren von Phosphor ein Emitterbereich vom n-Typ erzeugt werden. Alternativ können die Emitterbereiche jedoch auch durch andere Verfahren wie zum Beispiel durch Ionenimplantation oder Legieren erzeugt werden, so dass sich eine sogenannte Homo-Junction, das heißt ein pn-Übergang mit gegensätzlich dotierten Bereichen eines gleichen Halbleitergrundmaterials, zum Beispiel Silizium, ergibt. Alternativ können die Emitterbereiche auch epitaktisch abgeschieden werden, beispielsweise durch Aufdampfen oder Aufsputtern, so dass sich Homo- oder sogenannte Hetero-Junctions ergeben, das heißt im letzteren Falle pn-Übergänge zwischen einem ersten Halbleitermaterial vom Basis-Halbleitertyp und einem zweiten Halbleitermaterial vom Emitter-Halbleitertyp. Ein mögliches Beispiel sind Emitterbereiche aus mittels der PECVD-Technik aufgebrachten Schichten aus amorphem Silizium (a-Si) auf einem Halbleitersubstrat aus kristallinem Silizium (c-Si).

Die länglichen Basisbereiche an der Rückseiten-Oberfläche des Halbleitersubstrats können entweder Bereiche sein, die bei der Erzeugung der Emitterbereiche im Halbleitersubstrat ausgespart wurden und damit vom Basis-Halbleitertyp verblieben sind, oder sie können mittels eines der oben für die Erzeugung der Emitterbereiche beschriebenen Herstellungsverfahren erzeugt werden.

Zur Erzeugung der feinen Emitter- und Basisbereiche können beispielsweise Fotolithographie-Verfahren eingesetzt werden. Alternativ können entsprechende Masken, die beispielsweise durch Laserstrukturieren hergestellt werden können, verwendet werden.

Die länglichen Emitterbereiche und/oder die länglichen Basisbereiche können eine zusätzliche Schicht, z.B. aus ITO (Indium Tin Oxide). zur Verstärkung der lateralen Leitfähigkeit aufweisen.

Eine für die Funktionsweise der Solarzelle sinnvolle komplementäre Art der Anordnung der Basis- und Emitterbereiche an der Rückseite der Solarzelle kann in technologisch einfacher Weise dadurch erzeugt werden, dass zunächst an der Rückseite der Solarzelle ganzflächig Emitter (bzw. Basis) erzeugt wird, und anschließend durch lokales Einbringen von Dotierstoffen durch zum Beispiel Ionenimplantation oder Diffusion von Dotierstoffen durch zum Beispiel ein strukturierte Diffusionsmaske, an den gewünschten Stellen Basis- (bzw. Emitter-) Bereiche erzeugt werden, die die erstgenannte, ganzflächige Emitter- (bzw. Basis-) Schicht lokal überkompensieren.

Eine weitere Alternative stellt die zunächst großflächige Erzeugung beispielsweise eines Emitterbereichs dar, wobei der Emitterbereich anschließend durch lokales Abtragen von Teilbereichen beispielsweise mittels eines Lasers zu feineren Strukturbreiten hin ausgebildet werden kann.

Die Emitter- und die Basisbereiche können, in einer Draufsicht auf die Rückseiten-Oberfläche des Halbleitersubstrats gesehen, jeweils als kammartige Struktur ausgebildet sein, bei der jeweils fingerartige lineare Emitterbereiche an benachbarte fingerartige lineare Basisbereiche angrenzen. Eine solche verschachtelte Struktur wird auch als "interdigitated" bezeichnet. Die kammartige Struktur braucht nicht über die gesamte Zelloberfläche hin in gleicher Weise ausgebildet sein. Sie kann an Besonderheiten in bestimmten Bereichen der Zelloberfläche angepasst sein. Zum Beispiel kann in Regionen unterhalb der Basis-Busbars eine andere Struktur gewählt werden als in Regionen unterhalb der Emitter-Busbars. Desweitern kann diese Struktur auch rein ausschließlich an bestimmten Stellen der Zelle vorliegen, zum Beispiel im Bereich der Busbars oder Lötpads.

Sowohl die Emitterkontakte als auch die Basiskontakte können jeweils in Form einer lokalen Metallisierung beispielsweise in Form fingerartiger Grids ausgebildet sein. Hierzu können Metalle wie beispielsweise Silber oder Aluminium lokal beispielsweise durch eine Maske oder unter Verwendung von Fotolithographie auf der Rückseiten-Oberfläche der Solarzelle abgeschieden werden, beispielsweise durch Aufdampfen oder Aufsputtern oder auch durch Verwendung von Siebdruck- oder Dispensverfahren. Generell können alle Verfahren verwendet werden, die es ermöglichen, Kontakte lokal, beispielsweise Finger- oder Gridförmig, an einer Substratrückseite auszubilden, einschließlich der Möglichkeit, ganzflächige Metallschichten aufzubringen, die im Nachhinein durch lokales Entfernen strukturiert werden. Zur Vermeidung von Kurzschlüssen zwischen den Emitterkontakten und den Basiskontakten kann zwischen den beiden jeweils ein elektrisch isolierender Spalt vorgesehen sein.

Gemäß einer Ausführungsform der vorliegenden Erfindung ist eine gemittelte Strukturbreite der länglichen Emitterbereiche und/oder der länglichen Basisbereiche wenigstens 10 %, vorzugsweise wenigstens 20 % und stärker bevorzugt wenigstens 50 % kleiner als eine gemittelte Strukturbreite der länglichen Emitterkontakte und/oder der länglichen Basiskontakte. Beispielsweise können die Emitter- und Basisbereiche Strukturbreiten im Bereich von 5 bis 500 µm aufweisen und die Emitter- und Basiskontakte können entsprechend größere Strukturbreiten im Bereich von 200 µm bis 2 mm aufweisen.

Die Strukturbreiten der Emitter- und Basisbereiche können beispielsweise so gewählt werden, dass der gemittelte Abstand zwischen benachbarten Emitterbereichen, der bei ineinander verschachtelten Strukturen etwa der Strukturbreite der Basisbereiche entspricht, kleiner oder im Wesentlichen gleich der effektiven Minoritätsladungsträgerdiffusionslänge in dem Halbleitersubstrat ist, so dass Licht-generierte Ladungsträger effizient an den durch die Emitterbereiche ausgebildeten pn-Übergängen gesammelt werden können. Andererseits kann die gemittelte Strukturbreite der Emitterbereiche, die im Wesentlichen dem Abstand zwischen benachbarten Basisbereichen entspricht, so gewählt sein, dass Serienwiderstände bezogen auf zu den Basisbereichen driftende Majoritätsladungsträgern möglichst gering gehalten werden.

Die Strukturbreiten der Emitter- und Basiskontakte können so gewählt sein, dass die Kontakte einerseits technologisch einfach herstellbar sind und insbesondere eine Kontakttrennung zwischen Emitter- und Basiskontakten zuverlässig gewährleistet werden kann, und dass andererseits die Abstände zwischen benachbarten länglichen Emitterkontakten bzw. Basiskontakten klein genug sind, so dass Ladungsträger keine weiten lateralen Strecken durch schwach dotierte Basisbereiche bis zu einem Kontakt zurückzulegen brauchen, und so dass der Transport der elektrischen Ladungsträger entlang der mindestens zum Teil länglichen und relativ stark dotierten Emitter- und Basis-Bereiche bis zu einem jeweiligen Kontakt keine wesentlichen Serienwiderstandsverluste erzeugt.

Gemäß einer weiteren Ausführungsform der vorliegenden Erfindung sind mehrere längliche Emitterbereiche und mehrere längliche Basisbereiche jeweils abwechselnd aneinander angrenzend und parallel zueinander angeordnet und mehrere längliche Emitterkontakte und mehrere längliche Basiskontakte sind jeweils abwechselnd und parallel zueinander angeordnet. Der Mittenabstand zwischen benachbarten Emitter- und Basisbereichen ist hierbei kleiner als der Mittenabstand zwischen benachbarten Emitter- und Basiskontakten.

Mit anderen Worten können die Emitter- und Basisbereiche wie auch die Emitter- und Basiskontakte jeweils als ineinander verzahnte Strukturen ausgebildet sein, wobei ein Verzahnungsgrad, der als Anzahl von benachbarten Bereichen bzw. Kontakten pro Einheitsfläche definiert werden kann, für die Emitter- und Basisbereiche größer ist als für die Emitter- und Basiskontakte.

Gemäß einer weiteren Ausführungsform der vorliegenden Erfindung queren längliche Emitterkontakte längliche Basisbereiche, wobei die länglichen Basisbereiche von den sie querenden länglichen Emitterkontakten durch eine elektrisch isolierende Schicht isoliert sind.

Mit anderen Worten können zumindest einige der länglichen Emitterkontakte zumindest in Teilbereichen quer, beispielsweise senkrecht, über darunter liegende Basisbereiche verlaufen. Damit es in diesem Fall nicht zu lokalen Kurzschlüssen in der Solarzelle kommt, sind die Emitterkontakte dort gegenüber den darunter verlaufenden Basisbereichen durch eine elektrisch isolierende Schicht isoliert. Die elektrisch isolierende Schicht kann beispielsweise eine auf der Rückseiten-Oberfläche des Halbleitersubstrats aufgebrachte Dielektrikumschicht z.B. aus Siliziumnitrid oder Siliziumoxid oder auch eine Schicht aus einem organischen Lack sein. Die Schicht kann beispielsweise zunächst ganzflächig auf die Rückseiten-Oberfläche aufgebracht werden und dann an den Stellen, an denen eine elektrische Verbindung zwischen einem Kontakt und einem darunter liegenden Emitter- bzw. Basisbereich hergestellt werden soll, lokal geöffnet werden.

Gemäß einer weiteren Ausführungsform der vorliegenden Erfindung ist die Rückkontaktsolarzelle derart ausgebildet, dass eine elektrische Leitfähigkeit in den länglichen Basisbereichen an der Rückseiten-Oberfläche des Halbleitersubstrats höher ist als in Basisbereichen im Innern des Halbleitersubstrats.

Mit anderen Worten sind die länglichen Basisbereiche nicht lediglich Bereiche, in denen keine Emitter-Dotierung vorgenommen wurde, und die daher die gleiche Dotierung haben wie das ursprüngliche Halbleitersubstrat. Stattdessen können die Basisbereiche eine im Vergleich zum Halbleitersubstrat erhöhte Dotierungskonzentration vom Basis-Halbleitertyp, beispielsweise mehr als 1*10¹⁸ cm⁻³, vorzugsweise mehr als 1*10¹⁹cm⁻³, stärker bevorzugt mehr als 5*10¹⁹cm⁻³ und noch stärker bevorzugt mehr als 1*10²⁰cm⁻³, aufweisen und somit eine erhöhte Leitfähigkeit. Beispielsweise können die länglichen Basisbereiche durch einen zusätzlichen Diffusionsprozessschritt, bei dem Dotanden zur Erzeugung des Basis-Halbleitertyps lokal an der Halbleitersubstrat-Rückseite eindiffundiert werden, erzeugt werden.

Durch eine erhöhte Leitfähigkeit innerhalb der länglichen Basisbereiche kann erreicht werden, dass Majoritätsladungsträger mit nur geringen Serienwiderstandsverlusten bzw. über vergleichsweise lange Distanzen ohne wesentlichen Widerstandsverlust entlang der gut leitfähigen länglichen Basisbereiche hin zu den zu diesen quer verlaufenden Basiskontakten geleitet werden können.

Insbesondere dann, wenn gemäß einer weiteren bevorzugten Ausführungsform die Emitterbereiche und die Basisbereiche entlang der Rückseiten-Oberfläche des Halbleitersubstrats im Wesentlichen homogen verteilt sind, d.h. zum Beispiel so fein verteilt sind, dass die Abstände zwischen den relativ stark dotierten rückseitigen Basisbereichen vorzugsweise über die gesamte Rückseiten-Oberfläche der Solarzelle klein sind, , kann dadurch erreicht werden, dass Majoritätsladungsträger überall in dem Basis-artigen Hauptvolumen des Halbleitersubstrats lediglich geringe Strecken zurücklegen müssen, bevor sie in einen gut leitfähigen länglichen Basisbereich gelangen, wo sie dann ohne weitere wesentliche Serienwiderstandsverluste zu den Basiskontakten geleitet werden können. Auf diese Weise kann der Gesamtserienwiderstand der Solarzelle reduziert werden. Unter einer vorzugsweise homogenen Verteilung von feinen länglichen Basis- bzw. Emitterbereichen kann dabei verstanden werden, dass die Abstände zwischen den rückseitigen relativ stark dotierten Basisbereichen ausreichend gering sind, so dass bei den erwarteten Kurzschluss-Stromdichten der Solarzelle und dem durch Substratdicke, -Dotierung und Ladungsträgerbeweglichkeit gegebenen Widerstand des Substrates zwischen den rückseitigen Basisbereichen im Halbleitersubstrat kein wesentlicher Spannungsabfall auftritt. Strukturbreiten der Emitterbereiche und der Basisbereiche können dabei gleich groß sein, alternativ können die Emitterbereiche aber auch breiter als die Basisbereiche gewählt werden, um einen möglichst großflächigen, Ladungsträger-sammelnden pn-Übergang auszubilden.

Gemäß einem weiteren Aspekt der vorliegenden Erfindung wird ein Verfahren zum Herstellen einer Rückkontaktsolarzelle beschrieben, das die folgenden Schritte aufweist: Bereitstellen eines Halbleitersubstrats vom Basis-Halbleitertyp; Ausbilden länglicher Emitterbereiche vom Emitter-Halbleitertyp an einer Rückseiten-Oberfläche des Halbleitersubstrats; Ausbilden länglicher Basisbereiche vom Basis-Halbleitertyp an der Rückseiten-Oberfläche des Halbleitersubstrats; Ausbilden länglicher Emitterkontakte quer zu den länglichen Emitterbereichen zur elektrischen Kontaktierung der Emitterbereiche; Ausbilden länglicher Basiskontakte quer zu den länglichen Basisbereichen zur elektrischen Kontaktierung der Basisbereiche. Die länglichen Emitterbereiche weisen hierbei kleinere Strukturbreiten auf als die länglichen Emitterkontakte und die länglichen Basisbereiche weisen kleinere Strukturbreiten auf als die länglichen Basiskontakte.

Die Emitterbereiche und die Basisbereiche können mittels unterschiedlicher Verfahren erzeugt werden, beispielsweise durch lokales Eindiffundieren unter Verwendung beispielsweise von Masken oder Lithographie, durch Ionenimplantation, durch lokales Einlegieren, durch epitaktisches Aufbringen entsprechender Schichten, etc.

Auch die Emitter- und Basiskontakte können mittels verschiedener Verfahren ausgebildet werden, beispielsweise durch lokales Aufdampfen zum Beispiel unter Verwendung von Masken oder Lithographie, oder durch Aufsputtern oder auch durch Verwendung von Siebdruck- oder Dispensverfahren. Generell können alle Verfahren verwendet werden, die es ermöglichen, Kontakte lokal, beispielsweise Finger- oder Grid-förmig, an einer Substratrückseite auszubilden, einschließlich der Möglichkeit, ganzflächige Metallschichten aufzubringen, die im Nachhinein durch lokales Entfernen strukturiert werden. Das heißt neben anderem, dass die Kontakte auch zunächst als gemeinsame, die gesamte Rückseiten-Oberfläche der Solarzelle bedeckende Metallschicht ausgebildet werden können, wobei anschließend eine Kontakttrennung zwischen den Emitter- und Basisbereichen zum Beispiel durch lokales Entfernen von Metall beispielsweise durch Wegätzen oder Weglasern erreicht werden kann.

Es wird angemerkt, dass die Ausführungsformen, Merkmale und Vorteile der Erfindung hauptsächlich in Bezug auf die erfindungsgemäße Rückkontaktsolarzelle beschrieben wurden. Ein Fachmann wird jedoch aus der vorangehenden und auch aus der nachfolgenden Beschreibung erkennen, dass, sofern dies nicht anders angegeben ist, die Ausführungsformen und Merkmale der Erfindung auch analog auf das erfindungsgemäße Herstellungsverfahren für eine Solarzelle übertragen werden können. Insbesondere können die Merkmale der verschiedenen Ausführungsformen auch in beliebiger Weise untereinander kombiniert werden.

### KURZE BESCHREIBUNG DER ZEICHNUNGEN

Weitere Merkmale und Vorteile der vorliegenden Erfindung werden dem Fachmann aus der nachfolgenden Beschreibung von beispielhaften Ausführungsformen, die jedoch nicht als die Erfindung beschränkend auszulegen ist, und unter Bezugnahme auf die begleitenden Zeichnungen ersichtlich.
Fig. 1 zeigt eine Draufsicht auf die Rückseite einer Rückkontaktsolarzelle gemäß einer Ausführungsform der vorliegenden Erfindung.
Fig. 2 zeigt eine Draufsicht auf die Kontaktstruktur der in Fig. 1 dargestellten Ausführungsform.
Fig. 3 zeigt eine Querschnittsdarstellung entlang der Ebene A-A aus Fig. 1.
Fig. 4 zeigt eine Querschnittsdarstellung entlang der Ebene B-B aus Fig. 1.
Fig. 5 zeigt eine Draufsicht auf die Rückseite einer Rückkontaktsolarzelle gemäß einer weiteren Ausführungsform der vorliegenden Erfindung.
Fig. 6 zeigt eine Draufsicht auf die Rückseite einer Rückkontaktsolarzelle gemäß einer weiteren Ausführungsform der vorliegenden Erfindung.
Fig. 7 zeigt eine Querschnittsdarstellung einer herkömmlichen Rückkontaktsolarzelle.
Fig. 8 zeigt eine Draufsicht auf die Rückseite der herkömmlichen Rückkontaktsolarzelle aus Fig. 7.
Fig. 9 zeigt eine Querschnittsdarstellung einer weiteren herkömmlichen Rückkontaktsolarzelle.

Alle Figuren sind lediglich schematisch und nicht maßstabsgetreu. In den Figuren sind ähnliche oder gleiche Elemente mit gleichen Bezugszeichen beziffert.

### DETAILLIERTE BESCHREIBUNG BEVORZUGTER AUSFÜHRUNGSFORMEN

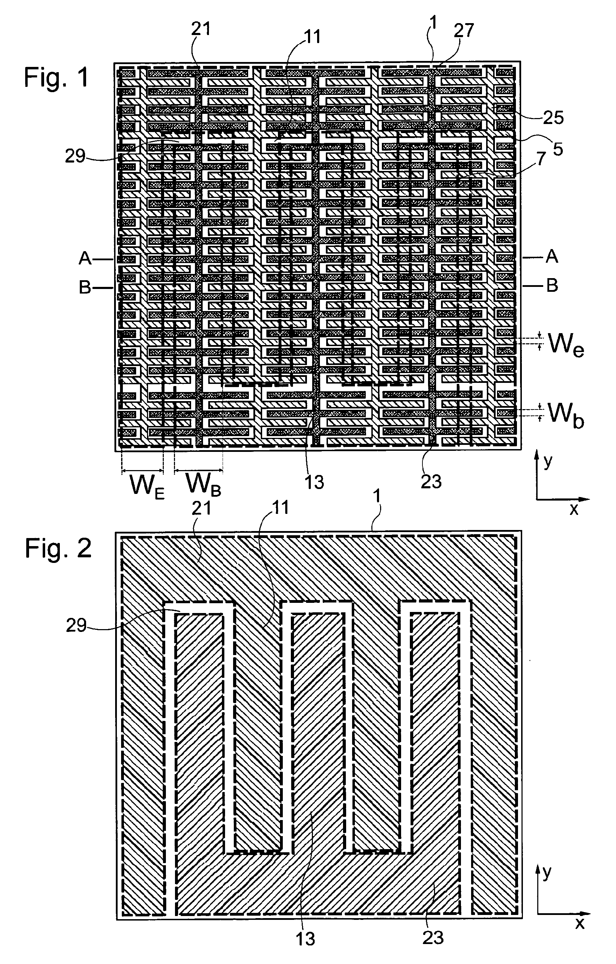

In Fig. 1 ist eine Ausführungsform einer Rückkontaktsolarzelle in Draufsicht auf deren Rückseite gezeigt. Aus zeichnerischen Gründen wurden die Emitter- und Basiskontakte 11, 13 durchscheinend, mit gestrichelter Umrandung dargestellt, so dass die darunter liegenden Emitter- und Basisbereiche 5, 7 erkennbar sind. Zur Verdeutlichung ist die Struktur der Emitter- und Basiskontakte 11, 13 nochmal separat in Fig. 2 gezeigt. Es wurden lediglich vier Emitterkontaktfinger dargestellt, wobei jedoch selbstverständlich ist, dass eine reale Solarzelle eine Vielzahl solcher Emitterkontaktfinger aufweist und dass auch deren Abmessungen in den Figuren nicht maßstabsgetreu wiedergegeben ist.

Wie in Fig. 1 zu erkennen, befinden sich an der Rückseiten-Oberfläche eines Halbleitersubstrats 1 längliche, fingerförmige Emitterkontakte 11, die parallel zueinander im Wesentlichen längs der gesamten Rückseiten-Oberfläche verlaufen. Die Emitterkontaktfinger 11 münden an einem Rand der Solarzelle in einen zu den Fingern 11 quer verlaufenden Emitter-Busbar 21.

Versetzt zu den Emitter-Fingern 11 erstrecken sich parallel zueinander und mit den Emitterkontaktfingern verzahnt mehrere Basiskontaktfinger 13. Diese münden in einen BasisBusbar 23 am gegenüberliegenden Rand der Solarzelle.

Quer zu den in der Zeichnung in y-Richtung verlaufenden Emitter- und Basiskontaktfingern 11, 13 verlaufen an der Rückseiten-Oberfläche 3 des Halbleitersubstrats 1 längliche Emitterbereiche 5 und längliche Basisbereiche 7. Parallel zueinander verlaufende längliche Emitterbereiche 5 wie auch parallel zueinander verlaufende Basisbereiche 7 sind jeweils in deren Mitte durch quer zu den Bereichen 5, 7 verlaufende Verbindungsstücke 25, 27 miteinander verbunden, so dass sich jeweils ein Fischgrätenmuster ergibt. Die länglichen Emitter- und Basisbereiche verlaufen in der Zeichnung in x-Richtung, das heißt orthogonal zur Richtung der Emitter- und Basiskontaktfinger 11, 13.

Eine Strukturbreite W_{E}W_{B} der Emitter- bzw. Basiskontaktfinger ist etwa drei bis vier Mal so groß wie eine Strukturbreite Wₑ, W_{b} der dazu quer verlaufenden Emitter- bzw. Basisbereiche 5, 7.

Wie in den Fign. 2 und 3 erkennbar, sind die Emitter- und Basiskontakte 11, 13 in weiten Bereichen der Rückseiten-Oberfläche 3 durch eine elektrisch isolierende Schicht 9 in Form einer Dielektrikumschicht von den Emitterbereichen 5 und den Basisbereichen 7 getrennt. Lediglich an Öffnungen 15, 17 in der isolierenden Schicht 9 können die Kontakte 11, 13 die darunter liegenden Bereiche 5, 7 lokal kontaktieren.

Sowohl die Emitterbereiche 5 als auch die Basisbereiche 7 wurden in das Halbleitersubstrat 1 an dessen Rückseite eindiffundiert und weisen aufgrund einer erhöhten Dotandenkonzentration eine vergrößerte Leitfähigkeit auf. Da die Emitterbereiche 5 seitlich, in x-Richtung über eine von dem darüber liegenden Emitterkontakt 11 bedeckte Region hinausragen, sogar bis in das Gebiet des benachbarten Basiskontakts 13, können aufgrund des entstehenden pn-Übergangs auch dort Ladungsträger effizient eingesammelt werden und dann mit geringen Serienwiderstandsverlusten entlang der hoch dotierten Emitterbereiche 5 hin zum Emitterkontakt 11 geleitet werden. Analoges gilt für die Basiskontakte 13 und die Basisbereiche 7. Somit können aufgrund der feinen Verzahnung von Emitter- und Basisbereichen 5, 7 sowohl gute Sammeleigenschaften als auch geringe Serienwiderstände realisiert werden.

Im Vergleich zu den Emitter- und Basisbereichen 5, 7 weisen die Emitter- und Basiskontakte 11, 13 eine wesentlich gröbere Verzahnung auf. Solch grobe Strukturen der Metallisierung mit Größenordnungen beispielsweise im Bereich von mehr als einem Millimeter können technologisch einfach und zuverlässig hergestellt werden, insbesondere, da der Spalt 29 zwischen Emitterkontakten 11 und Basiskontakten 13 dann ohne wesentlichen Verlust an metallisierter Fläche verhältnismäßig breit ausgebildet werden kann, beispielsweise mit einer Breite von wenigen 100 µm, was eine zuverlässige Isolation zwischen den Kontakten sichert.

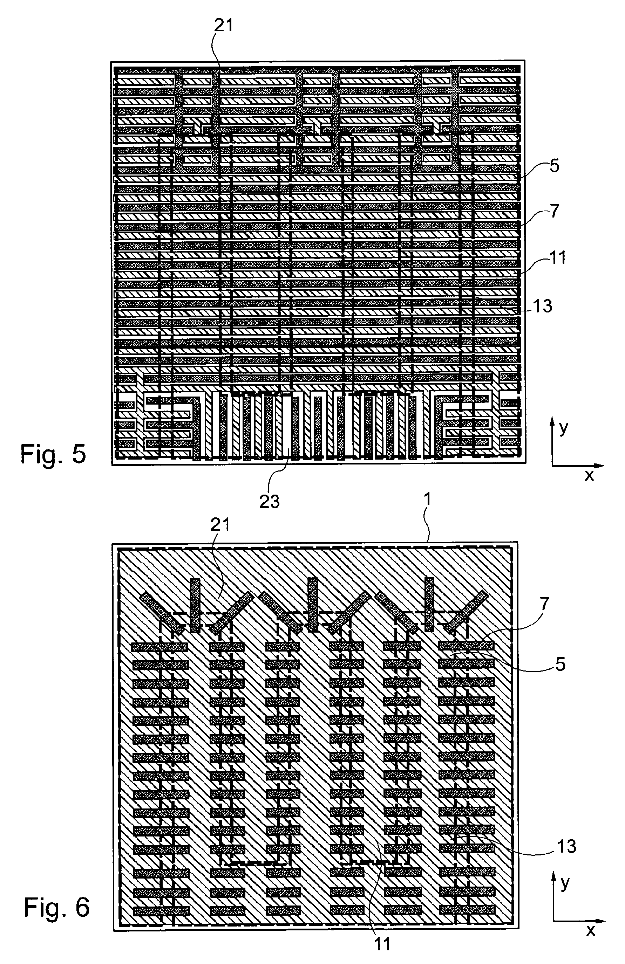

In Fig. 5 ist eine alternative Ausführungsform einer erfindungsgemäßen Solarzelle in Draufsicht auf deren Rückseite dargestellt. Bei dieser Ausführungsform ist das aus Emitterbereichen 5 und Basisbereichen 7 bestehende Muster zumindest in Regionen außerhalb der Busbars 21, 23 sehr einfach gehalten, nämlich in Form von alternierend angeordneten länglichen, schmalen Bereichen 5, 7, die an das Muster eines Zebrastreifens erinnern. Die einander benachbarten Emitter- bzw. Basisbereiche 5, 7 sind dabei nicht mehr in y-Richtung durch zusätzliche Verbindungsbereiche innerhalb des Halbleitersubstrats miteinander verbunden. Stattdessen findet eine solche elektrische Verbindung lediglich durch die quer dazu verlaufenden und jeweils die einzelnen Emitter- bzw. Basisbereiche 5, 7 lokal kontaktierenden Emitter- bzw. Basiskontakte 11, 13 statt.

In Fig. 6 ist eine weitere Ausführungsform gezeigt, bei der der Emitter einen Großteil der Rückseiten-Oberfläche bedeckt und sich lediglich in Teilbereichen in der Region am Rand der Basiskontakte 13 längliche Basisbereiche 7 befinden, die in die Regionen unterhalb der Emitterkontakte 11 hineinreichen. Die stark dotierten Basisbereiche 7 können somit auch Majoritätsladungsträger, die in den Regionen der Emitterkontakte 11 generiert wurden, ohne wesentliche Serienwiderstandsverluste zu den Basiskontakten 13 hin ableiten. Zwischen den länglichen Basisbereichen 7 erstrecken sich ebenfalls längliche Emitterbereiche 5. In der Region der Spitzen der Finger der Basiskontakte 13 ragen längliche Emitterbereich-Finger 47 teilweise schräg bis weit unter die Region des Emitterbusbars 21, um auch von dort Ladungsträger verlustarm ableiten zu können.

Bei der in Fig. 6 dargestellten Ausführungsform wurde das Konzept der länglichen Emitter- und Basisbereiche 5, 7, die quer zu den länglichen Kontakten 11, 13 verlaufen, in besonders optimierter Weise umgesetzt. Einerseits sind nur wenige längliche Basisbereiche notwendig, sodass die Erzeugung dieser Bereiche einfach durchzuführen ist. Andererseits sind diese Bereiche genau dort vorgesehen, wo sie gezielt zur effizienten, verlustarmen Ableitung von Ladungsträgern aus Regionen unterhalb der Emitterkontakte 11 und Emitterbusbars 21 beitragen. Die zwischen den länglichen Basisbereichen 7 verlaufenden länglichen Emitterbereiche 5 stellen dabei gleichzeitig eine gut leitende Verbindung zu den den pn Übergang bildenden und somit stromsammelnden Emittergebieten unter den Basiskontakten 13 und Basisbusbars 23 dar.

Aufgrund der vorangehenden Beschreibung ist dem Fachmann klar, dass das der Erfindung zugrunde liegende Prinzip durch eine Vielzahl konkreter Ausgestaltungen realisiert werden kann. Insbesondere die Ausgestaltung der Emitter- und Basisbereiche sowie der Emitter- und Basiskontakte hinsichtlich ihrer Geometrie und Anordnung sowie hinsichtlich deren Herstellung kann stark variiert werden, ohne vom Grundgedanken der Erfindung , wie er in den unabhängige Ansprüchen beschrieben ist, abzuweichen.

Abschließend wird darauf hingewiesen, dass die Begriffe "umfassend", "aufweisen", etc. das Vorhandensein weiterer Elemente nicht ausschließen. Der Begriff "ein" schließt auch das Vorhandensein einer Mehrzahl von Gegenständen nicht aus. Die Bezugszeichen in den Ansprüchen dienen lediglich der besseren Lesbarkeit und sollen den Schutzbereich der Ansprüche in keiner Weise beschränken.

## Patentansprüche

1. Rückkontaktsolarzelle, aufweisend:
ein Halbleitersubstrat (1);
längliche Basisbereiche (7) an der Rückseiten-Oberfläche (3) des Halbleitersubstrates (1), wobei die Basisbereiche (7) einen Basis-Halbleitertyp aufweisen;
längliche Emitterbereiche (5) an einer Rückseiten-Oberfläche (3) des Halbleitersubstrates (1), wobei die Emitterbereiche (5) einen dem Basis-Halbleitertyp entgegengesetzten Emitter-Halbleitertyp aufweisen;
längliche Emitterkontakte (11) quer zu den länglichen Emitterbereichen (5) zur elektrischen Kontaktierung der Emitterbereiche (5);
längliche Basiskontakte (13) quer zu den länglichen Basisbereichen (7) zur elektrischen Kontaktierung der Basisbereiche (7);
wobei mehrere längliche Emitterbereiche (5) und mehrere längliche Basisbereiche (7) jeweils abwechselnd benachbart aneinander angrenzend und parallel zueinander angeordnet sind und wobei mehrere längliche Emitterkontakte (11) und mehrere längliche Basiskontakte (13) jeweils abwechselnd und parallel zueinander angeordnet sind,
wobei die länglichen Emitterbereiche (5) kleinere Strukturbreiten aufweisen als die länglichen Emitterkontakte (11) und wobei die länglichen Basisbereiche (7) kleinere Strukturbreiten aufweisen als die länglichen Basiskontakte (13),
und wobei der Mittenabstand (Wₑ, W_{b}) zwischen benachbarten Emitter- und
Basisbereichen kleiner ist als der Mittenabstand (W_{E}, W_{B}) zwischen benachbarten Emitter- und Basiskontakten.

2. Rückkontaktsolarzelle nach Anspruch 1, wobei eine gemittelte Strukturbreite der länglichen Emitterbereiche (5) und/oder der länglichen Basisbereiche (7) wenigstens 10% kleiner ist als eine gemittelte Strukturbreite der länglichen Emitterkontakte (11) und/oder der länglichen Basiskontakte (13) im gleichen Flächenbereich der Solarzelle.

3. Rückkontaktsolarzelle nach einem der Ansprüche 1 bis 2, wobei längliche Emitterkontakte (11) längliche Basisbereiche (7) queren und wobei die länglichen Basisbereiche (7) von den sie querenden länglichen Emitterkontakten (11) durch eine elektrisch isolierende Schicht (9) isoliert sind.

4. Rückkontaktsolarzelle nach einem der Ansprüche 1 bis 3, wobei längliche Basiskontakte (13) längliche Emitterbereiche (5) queren und wobei die länglichen Emitterbereiche (5) von den sie querenden länglichen Basiskontakten (13) durch eine elektrisch isolierende Schicht (9) isoliert sind.

5. Rückkontaktsolarzelle nach einem der Ansprüche 1 bis 4, wobei eine elektrische Leitfähigkeit in den länglichen Basisbereichen (7) an der Rückseiten-Oberfläche (3) des Halbleitersubstrates (1) höher ist als in Basisbereichen im Innern des Halbleitersubstrates (1).

6. Rückkontaktsolarzelle nach einem der Ansprüche 1 bis 5, wobei die Emitterbereiche und die Basisbereiche (5, 7) entlang der Rückseiten-Oberfläche (3) des Halbleitersubstrates (1) im Wesentlichen homogen verteilt sind.

7. Rückkontaktsolarzelle nach einem der Ansprüche 1 bis 6, wobei längliche Basisbereiche (47) in von einem Emitterbusbar (21) überdeckte Regionen ragen.

8. Rückkontaktsolarzelle nach einem der Ansprüche 1 bis 7, wobei längliche Emitterbereiche (5) in von einem Basisbusbar (23) überdeckte Regionen ragen.

9. Verfahren zum Herstellen einer Solarzelle, aufweisend:
Bereitstellen eines Halbleitersubstrats (1);
Ausbilden länglicher Basisbereiche (7) an der Rückseiten-Oberfläche (3) des Halbleitersubstrates (1), wobei die Basisbereiche (7) einen Basis-Halbleitertyp aufweisen;
Ausbilden länglicher Emitterbereiche (5) an einer Rückseiten-Oberfläche (3) des Halbleitersubstrates (1), wobei die Emitterbereiche (5) einen dem Basis-Halbleitertyp entgegengesetzten Emitter-Halbleitertyp aufweisen;
Ausbilden länglicher Emitterkontakte (11) quer zu den länglichen Emitterbereichen (5) zur elektrischen Kontaktierung der Emitterbereiche (5);
Ausbilden länglicher Basiskontakte (13) quer zu den länglichen Basisbereichen (7) zur elektrischen Kontaktierung der Basisbereiche (7);
wobei mehrere längliche Emitterbereiche (5) und mehrere längliche Basisbereiche (7) jeweils abwechselnd benachbart aneinander angrenzend und parallel zueinander angeordnet sind und wobei mehrere längliche Emitterkontakte (11) und mehrere längliche Basiskontakte (13) jeweils abwechselnd und parallel zueinander angeordnet sind,
wobei die länglichen Emitterbereiche (5) kleinere Strukturbreiten aufweisen als die länglichen Emitterkontakte (11) und wobei die länglichen Basisbereiche (7) kleinere Strukturbreiten aufweisen als die länglichen Basiskontakte (13),
und wobei der Mittenabstand (Wₑ, W_{b}) zwischen benachbarten Emitter- und Basisbereichen kleiner ist als der Mittenabstand (W_{E}, W_{B}) zwischen benachbarten Emitter- und Basiskontakten.

## Claims

1. Rear-contact solar cell, having:
a semiconductor substrate (1);
elongate base regions (7) on the rear side surface (3) of the semiconductor substrate (1), the base regions (7) having a base semiconductor type;
elongate emitter regions (5) on a rear side surface (3) of the semiconductor substrate (1), the emitter regions (5) having an emitter semiconductor type opposite to the base semiconductor type;
elongate emitter contacts (11) transverse to the elongate emitter regions (5) for electrically contacting the emitter regions (5);
elongate base contacts (13) transverse to the elongate base regions (7) for electrically contacting the base regions (7);
wherein a plurality of elongate emitter regions (5) and a plurality of elongate base regions (7) are each arranged alternately adjoining one another and parallel to one another and wherein a plurality of elongate emitter contacts (11) and a plurality of elongate base contacts (13) are each arranged alternately and parallel to one another,
wherein the elongate emitter regions (5) have smaller structural widths than the elongate emitter contacts (11) and wherein the elongate base regions (7) have smaller structural widths than the elongate base contacts (13), and wherein the centre-to-centre distance (Wₑ, W_{b}) between adjacent emitter and base regions is less than the centre-to-centre distance (W_{E}, W_{B}) between adjacent emitter and base contacts.

2. Rear-contact solar cell according to claim 1, wherein an averaged structural width of the elongate emitter regions (5) and/or of the elongate base regions (7) is at least 10 % less than an averaged structural width of the elongate emitter contacts (11) and/or of the elongate base contacts (13) in the same area region of the solar cell.

3. Rear-contact solar cell according to any one of claims 1 to 2, wherein elongate emitter contacts (11) traverse elongate base regions (7) and wherein the elongate base regions (7) are insulated from the elongate emitter contacts (11) traversing them by an electrically insulating layer (9).

4. Rear-contact solar cell according to any one of claims 1 to 3, wherein elongate base contacts (13) traverse elongate emitter regions (5) and wherein the elongate emitter regions (5) are insulated from the elongate base contacts (13) traversing them by an electrically insulating layer (9).

5. Rear-contact solar cell according to any one of claims 1 to 4, wherein an electrical conductivity is higher in the elongate base regions (7) on the rear side surface (3) of the semiconductor substrate (1) than in base regions in the interior of the semiconductor substrate (1).

6. Rear-contact solar cell according to any one of claims 1 to 5, wherein the emitter regions and the base regions (5, 7) are distributed substantially homogeneously along the rear side surface (3) of the semiconductor substrate (1).

7. Rear-contact solar cell according to any one of claims 1 to 6, wherein elongate base regions (47) protrude into regions covered by an emitter busbar (21).

8. Rear-contact solar cell according to any one of claims 1 to 7, wherein elongate emitter regions (5) protrude into regions covered by a base busbar (23).

9. Method for producing a solar cell, including:
providing a semiconductor substrate (1);
forming elongate base regions (7) on the rear side surface (3) of the semiconductor substrate (1), the base regions (7) having a base semiconductor type;
forming elongate emitter regions (5) on a rear side surface (3) of the semiconductor substrate (1), the emitter regions (5) having an emitter semiconductor type opposite to the base semiconductor type;
forming elongate emitter contacts (11) transversely to the elongate emitter regions (5) for electrically contacting the emitter regions (5);
forming elongate base contacts (13) transversely to the elongate base regions (7) for electrically contacting the base regions (7);
wherein a plurality of elongate emitter regions (5) and a plurality of elongate base regions (7) are each arranged alternately adjoining one another and parallel to one another and wherein a plurality of elongate emitter contacts (11) and a plurality of elongate base contacts (13) are each arranged alternately and parallel to one another,
wherein the elongate emitter regions (5) have smaller structural widths than the elongate emitter contacts (11) and wherein the elongate base regions (7) have smaller structural widths than the elongate base contacts (13),
and wherein the centre-to-centre distance (Wₑ, W_{b}) between adjacent emitter and base regions is less than the centre-to-centre distance (W_{E}, W_{B}) between adjacent emitter and base contacts.

## Revendications

1. Cellule solaire à contact arrière, présentant :
un substrat à semi-conducteur (1) ;
des zones de base (7) oblongues sur la surface (3) côté arrière du substrat à semi-conducteur (1), les zones de base (7) présentant un type de semi-conducteur de base ;
des zones émettrices (5) oblongues sur une surface (3) côté arrière du substrat à semi-conducteur (1), les zones émettrices (5) présentant un type de semi-conducteur émetteur inversé au type de semi-conducteur de base ;
des contacts émetteurs (11) oblongs transversaux aux zones émettrices (5) oblongues, destinés à la connexion électrique des zones émettrices (5) ;
des contacts de base (13) oblongs transversaux aux zones de base (7) oblongues, destinés à la connexion électrique des zones de base (7) ;
dans laquelle plusieurs zones émettrices (5) oblongues et plusieurs zones de base (7) oblongues sont disposées en étant respectivement adjacentes les unes aux autres de manière alternée et parallèles les unes aux autres et dans laquelle plusieurs contacts émetteurs (11) oblongs et plusieurs contacts de base (13) oblongs sont disposés de manière respectivement alternée et parallèle les uns aux autres,
dans laquelle les zones émettrices (5) oblongues présentent des largeurs de structure plus petites que les contacts émetteurs (11) oblongs et dans laquelle les zones de base (7) oblongues présentent des largeurs de structure plus petites que les contacts de base (13) oblongs,
et dans laquelle l'entraxe (Wₑ, W_{b}) entre des zones émettrices et des zones de base adjacentes est plus petit que l'entraxe (W_{E}, W_{B}) entre des contacts émetteurs et des contacts de base adjacents.

2. Cellule solaire à contact arrière selon la revendication 1, dans laquelle une largeur de structure moyenne des zones émettrices (5) oblongues et/ou des zones de base (7) oblongues est au moins 10% plus petite qu'une largeur de structure moyenne des contacts émetteurs (11) oblongs et/ou des contacts de base (13) oblongs dans la même zone de surface de la cellule solaire.

3. Cellule solaire à contact arrière selon l'une quelconque des revendications 1 à 2, dans laquelle des contacts émetteurs (11) oblongs croisent des zones de base (7) oblongues et dans laquelle les zones de base (7) oblongues sont isolées des contacts émetteurs (11) oblongs qui les croisent au moyen d'une couche (9) électriquement isolante.

4. Cellule solaire à contact arrière selon l'une quelconque des revendications 1 à 3, dans laquelle les contacts de base (13) oblongs croisent des zones émettrices (5) oblongues et dans laquelle les zones émettrices (5) oblongues sont isolées des contacts de base (13) oblongs qui les croisent au moyen d'une couche (9) électriquement isolante.

5. Cellule solaire à contact arrière selon l'une quelconque des revendications 1 à 4, dans laquelle une conductivité électrique dans les zones de base (7) oblongues situées sur la surface (3) côté arrière du substrat à semi-conducteur (1) est plus élevée que dans des zones de base situées à l'intérieur du substrat à semi-conducteur (1).

6. Cellule solaire à contact arrière selon l'une quelconque des revendications 1 à 5, dans laquelle les zones émettrices et les zones de base (5, 7) situées le long de la surface (3) côté arrière du substrat à semi-conducteur (1) sont réparties de manière essentiellement homogène.

7. Cellule solaire à contact arrière selon l'une quelconque des revendications 1 à 6, dans laquelle des zones de base (47) oblongues font saillie dans des régions recouvertes par une barre omnibus émettrice (21).

8. Cellule solaire à contact arrière selon l'une quelconque des revendications 1 à 7, dans laquelle des zones émettrices (5) font saillie dans des régions recouvertes par une barre omnibus de base (23).

9. Procédé de fabrication d'une cellule solaire, présentant :
fourniture d'un substrat à semi-conducteur (1) ;
réalisation de zones de base (7) oblongues sur la surface (3) côté arrière du substrat à semi-conducteur (1), les zones de base (7) présentant un type de semi-conducteur de base ;
réalisation de zones émettrices (5) oblongues sur une surface (3) côté arrière du substrat à semi-conducteur (1), les zones émettrices (5) présentant un type de semi-conducteur émetteur inversé au type de semi-conducteur de base ;
réalisation de contacts émetteurs (11) oblongs transversaux aux zones émettrices (5) oblongues, destinés à la connexion électrique des zones émettrices (5) ;
réalisation de contacts de base (13) oblongs transversaux aux zones de base (7) oblongues, destinés à la connexion électrique des zones de base (7) ;
dans lequel procédé plusieurs zones émettrices (5) oblongues et plusieurs zones de base (7) oblongues sont disposées en étant respectivement adjacentes les unes aux autres de manière alternée et parallèles les unes aux autres et dans lequel plusieurs contacts émetteurs (11) oblongs et plusieurs contacts de base (13) oblongs sont disposés de manière respectivement alternée et parallèle les uns aux autres,
dans lequel les zones émettrices (5) oblongues présentent des largeurs de structure plus petites que les contacts émetteurs (11) oblongs et dans lequel les zones de base (7) oblongues présentent des largeurs de structure plus petites que les contacts de base (13) oblongs,
et dans lequel l'entraxe (Wₑ, W_{b}) entre des zones émettrices et des zones de base adjacentes est plus petit que l'entraxe (W_{E}, W_{B}) entre des contacts émetteurs et des contacts de base adjacents.
